# EUROPEAN PATENT SPECIFICATION

(11) **EP 0 429 531 B1**
(45) Date of publication and mention of the grant of the patent: **23.04.1997**
(21) Application number: 89909841.2
(22) Date of filing: 18.08.1989
(51) Int. Cl.: H01P 3/14, H05K 9/00

(54) **ELECTROMAGNETIC SCREENING WITH AN ELASTOMERIC LAYER COMPRISING A METALLIC PARTICULATE FILLER**
ELEKTROMAGNETISCHE ABSCHIRMUNG MIT EINER ELASTOMERSCHICHT, DIE METALLISCHE PARTIKEL ENTHÄLT
ECRAN ELECTROMAGNETIQUE COMPRENANT UNE COUCHE EN ELASTOMERE CONTENANT DES PARTICULES DE METAL

(30) Priority: 19.08.1988 GB 8819774
(43) Date of publication of application: 05.06.1991
(73) Proprietor: JAMES WALKER & COMPANY LIMITED, Woking Surrey GU22 8AP (GB); QUASAR MICROWAVE TECHNOLOGY LIMITED, Newton Abbot, Devon TQ12 6XU (GB)
(72) Inventor: CLARKE, Trevor, Robert 5 Southwood Avenue, Surrey (GB); HELME, Barry, G. Quasar Microwave Technology Ltd., Cornwall PL14 4LQ (GB)
(74) Representative: Cozens, Paul Dennis
(86) International application number: GB8900968
(87) International publication number: WO9002426

(56) References cited:
- DE-A- 1 515 344
- US-A- 2 636 083
- US-A- 3 103 454
- US-A- 3 599 126
- US-A- 3 648 201
- US-A- 3 692 063

## Description

This invention relates to electromagnetic screening, including materials and structures suitable for use in the screening and/or construction of electromagnetic transmission line components. The structures may be laminated structures. The invention further relates to methods of electromagnetic screening and to novel constructions of electromagnetic transmission line components.

Electromagnetic transmission line components, such as, for example, wave guides, coaxial cables and microwave transmitting and receiving antenna components are customarily fabricated from or include sheet metal, braided metal wire or overlapping metal strips. Parts of these components which are electrically conductive are often designed to form barriers which screen regions lying on opposite sides thereof electromagnetically from one another.

Thus in a conventional wave guide the wave guide wall is effective in substantially preventing leakage of electromagnetic radiation from the interior of the wave guide to the surroundings and vice versa. Similarly in an electromagnetic transmission line component such as a microwave antenna, the conductive metal from which the component is formed acts to screen the interior of the component from extraneous electromagnetic radiation. In the case of a coaxial cable, the conventional outer metallic sheath, which may, for example, be formed from braided or spirally wound wire, performs a similar function.

In certain forms of construction of electromagnetic transmission line, the barrier which screens regions lying on opposite sides thereof electromagnetically from one another may be discontinuous. One example of such a transmission line is a coaxial cable of the kind described above having a metallic sheath formed from braided or spirally wound wire. Another example is a waveguide formed from a convoluted metal strip. Wave guides having this form of construction can be flexible and may be bent about one or more axes and/or twisted.

The effectiveness of conductive metal barriers of the kinds described is such that an electromagnetic screening effectiveness of 80 dB can customarily be attained.

However, in many applications, for example in situations where a high degree of security is required, or where highly sensitive or directional microwave receivers are required to be designed, an electromagnetic screening effectiveness of greater than 80 dB is desirable. There is accordingly a need for improved electromagnetic screening materials. This is particularly so in the case where the aforementioned barrier is discontinuous.

According to one aspect of the present invention there is provided a method of reducing or substantially eliminating leakage of electromagnetic radiation between first and second regions lying on opposite sides of a conductive metal barrier, which comprises providing a layer of material so as to overlie a substantial surface area portion of at least one surface of the barrier which faces one of the first and second regions, characterised in that said layer is a layer of conductive elastomeric material having a volume resistivity less than 0.01 Ω.cm and including a particulate electrically conductive filler consisting of a metal or metals in particulate form or particles of non-metal provided with a metallic coating.

A method according to the classifying portion of the preceding paragraph is known from US-A-3648201.

Various conductive polymeric materials are disclosed in the Encyclopedia of Polymer Science and Engineering, Second Edition, 1986, J. Wiley & Sons Inc., Vol. 5, "Electrically conducting polymers", pp. 462 to 505.

The invention further provides a structure for use in impeding the passage of electromagnetic radiation, said structure comprising a conductive metal barrier for screening first and second regions lying on opposite sides of the barrier electromagnetically from one another, and a layer of material overlying a substantial surface area portion of at least one surface of the barrier which faces one of the first and second regions, characterised in that said layer is a layer of conductive elastomeric material having a volume resistivity less than 0.01 Ω.cm and including a particulate electrically conductive filler consisting of a metal or metals in particulate form or particles of non-metal provided with a metallic coating.

The conductive elastomeric material preferably includes an elastomeric polymeric material.

The electrically conductive filler may be dispersed in the polymeric elastomer, and may for example consist of nickel particles, or particles of non-metals rendered conductive by being provided with a metallic coating. Suitable fillers include silver, silver plated copper, silver plated nickel, silver plated brass, silver plated aluminium and silver plated glass particles.

The precise size and shape of the filler particles is not critical although these can be optimised according to performance requirements. For example the particles can be generally spherical or they may be of irregular shape or in the form of rods or fibres. For spherical or irregular particles, a maximum transverse dimension of less than 200 µm is preferred.

A variety of polymeric elastomers may be used as binders for the dispersed electrically conductive filler. Preferably, however, polychloroprene-, silicone- or fluorosilicone- based elastomers are used. Phenyl-silicones are particularly useful. Preferably the electrically conductive filler and a curing agent are incorporated into uncured polymeric elastomer and the resulting mix cured by, for example, the application of heat.

Generally a high loading of electrically conductive filler is required in order for the resulting electrically conductive elastomeric material to have the required conductivity (namely a volume resistivity of less than 0.01 Ω.cm).

The mode of application of the layer of conductive elastomeric material to the conductive metal barrier is not critical and generally depends upon the nature of the barrier and the desired shape of the eventual structure. Thus, for example, the conductive elastomeric material may be applied by casting, by injection molding, by compression moulding, by using a spreading device or by applying a pre-formed layer of the conductive elastomeric material in sheet form.

The structure of the invention is particularly suitable for use in the formation of an electromagnetic transmission line component such as, for example, a wave guide, a coaxial line or a microwave antenna.

Thus the invention extends to an electromagnetic transmission line component comprising a structure as aforesaid.

Preferably, the component has interior and exterior regions separated by a conductive metal barrier arranged to screen the interior and exterior regions from one another, and a layer of a conductive elastomeric material overlying a substantial surface area portion of at least one surface of the barrier which faces one of the interior and exterior regions.

Where wave guide tubes are to be manufactured using the structure according to the invention, the physical form of the conductive metal barrier will depend, by and large, on the size and configuration of the desired wave guide tube. Thus, for example, where the wave guide tube is to be formed of metal strip, the thickness of the metal strip will be determined by such factors as the required rigidity of the tube, the dimensions of the wave guide and the desired frequency characteristics of the wave guide. Similarly, the thickness of the applied layer of electrically conductive elastomer will depend primarily upon the degree of screening required and the necessity to provide a coherent layer of elastomer. Thus, for example, the applied layer may be from 1 to 10 mm in thickness.

The metal used to form the conductive metal barrier in the structure according to the invention depends upon the intended use of the materials. Typical metals which may be used include beryllium-copper, brass, stainless steel, aluminium and titanium, any of which may be plated with another metal, for example a noble metal or silver.

The structure of the invention may include one or more layers in addition to the conductive metal barrier and the layer of conductive elastomeric material. For example a layer of bonding agent may be incorporated between the conductive metal barrier and the layer of conductive elastomeric material. Alternatively or additionally at least part of the surface of the conductive elastomeric material on the opposite side from the side facing the conductive metal barrier may be provided with an applied layer of non-conductive elastomeric material.

The application of an electrically conductive elastomeric material in accordance with the invention has been found to be particularly effective in screening flexible wave guide tube having a corrugated wall formation, especially where the wall has discontinuities. A particular example of such a wave guide is the flexible corrugated wave guide tubing manufactured by Quasar Microwave Technology Ltd and sold under the trade name "Flex-Twist". This tubing is characterised by a corrugated wall formation formed by winding metal strip in a convoluted, overlapping formation onto a former. In the manufacture of such tubing, the corrugations can be formed by simultaneously wrapping the former with the metal strip which eventually forms the wave guide wall and a wire support which is located between the former and the applied metal strip and supports the convolutions.

Wave guide tubing formed in this way is flexible and twistable.

As indicated above the present invention, in one of its embodiments, can increase the electromagnetic screening effectiveness of a conductive metal barrier by forming a structure comprising the barrier and an electrically conductive elastomer. It has, however, been found that in the case of certain forms of electromagnetic transmission line components, especially coaxial electromagnetic transmission lines, the conductive metal barrier can be wholly or partially replaced by a suitably configured structure formed of a conductive elastomeric material.

Thus according to a further aspect of the invention, there is provided a coaxial electromagnetic transmission line component having inner and outer electrically conductive elements electrically insulated from one another, characterised in that the outer electrically conductive element comprises a layer of electrically conductive elastomeric material having a volume resistivity of less than 0.01 Ω.cm and including a particulate electrically conductive filler consisting of a metal or metals in particulate form or particles of non-metal provided with a metallic coating.

The invention will now be described in more detail by way of example with particular reference to the accompanying drawings of which:-
Figure 1 represents a transverse cross-sectional view through a wave guide in accordance with the invention;
Figure 2 represents a longitudinal section through the wave guide of Figure 1;
Figure 3 represents an enlarged view of a surface portion of the wall of the wave guide; and
Figures 4 a-d represent schematic views of the wave guide of Figures 1-3 during stages of its manufacture.

Referring to the drawings, wave guide 10 consists of a rectangular spirally wound tube 12 formed of silver plated brass strip. The overall dimensions of the wave guide tube are width 22.3 mm, height 11.9 mm and length 80 mm. The exterior surfaces of the wave guide tube are clad with a two-part elastomeric coating. The coating comprises an inner elastomeric layer 14 formed of an electrically conductive elastomer and an outer elastomeric layer 16 which is non-conducting. The ends of the tube (not shown) may be provided with flanges enabling the tube to be connected to, for example, another tube section.

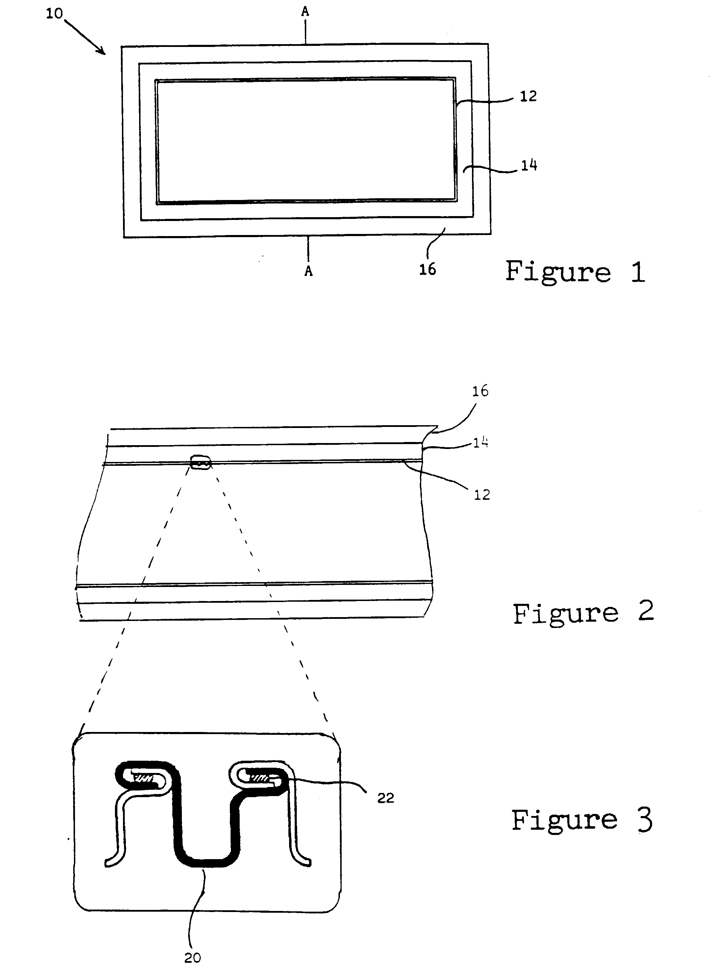

Referring to Figure 3, the metal wall of the wave guide is of convoluted configuration and is formed from silver plated brass strip 20. In producing the wave guide, the strip 20 is wound spirally around a rectangular former. Wires are simultaneously wound onto the former so as to support the corrugations and an additional wire 22 is compressed between adjacent turns of the tape in order to promote electrical continuity between adjacent turns.

The application of the layer of conductive elastomeric material in accordance with the invention will now be described in the following example.

### Example

A wave guide tube 12,was degreased in a vapour degreasing bath using a chlorinated hydrocarbon solvent.

A bonding agent composed of synthetic organic silicones in a methanol solvent system was painted onto the exterior surface of the wave guide and allowed to dry in air for 10 to 20 minutes.

An electrically conductive elastomeric material was prepared by compounding a peroxide cured vinyl methyl silicone based polymer, a curing agent and an electrically conductive filler. The proportions were adjusted to provide a compression set resistance better than 35% after 25% compression for 22 hours at 125°C and 30 minutes recovery, and a volume resistivity of less than 0.01Ω.cm.

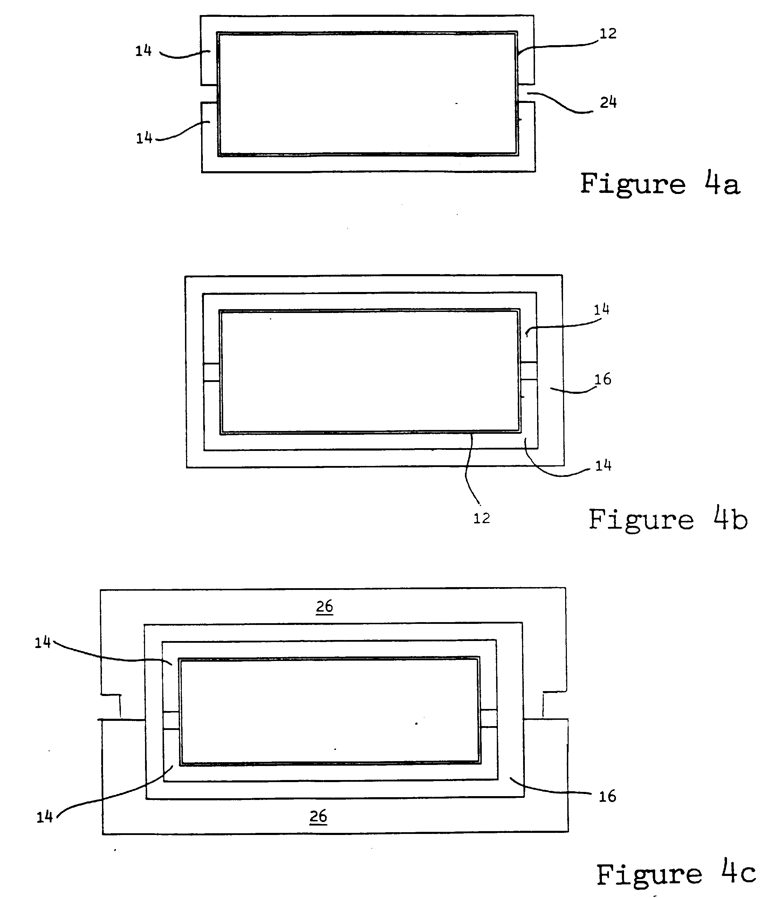

The ingredients were mixed and then formed into sheets in a two-roll mill. Sheet sections were cut to size and laid onto the broad sides of the microwave as shown in Figure 4a and folded over the narrow sides leaving a 5 mm gap 24 between the edges of the upper and lower sheets. A non-conductive elastomeric mix was similarly formulated, rolled into-sheet form and wrapped around the resulting composite structure (Figure 4b).

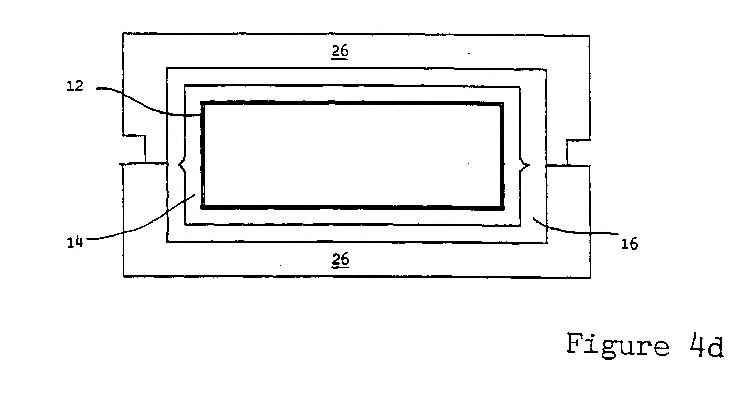

The double wrapped microwave tube was then compressed in a heated mould 26 (Figure 4c). During curing, the gaps 24 referred to above closed as a result of plastic flow of the conductive elastomer (Figure 4d).

When tested for leakage, it was found that the microwave tube formed in accordance with the invention had an electromagnetic screening effectiveness of greater than 110 dB. This represents a greater than 1000-fold improvement compared with the microwave tube without the applied conductive elastomeric material.

## Claims

1. A structure for use in impeding the passage of electromagnetic radiation, said structure comprising a conductive metal barrier (12) for screening first and second regions lying on opposite sides of the barrier electromagnetically from one another, and a layer (14) of material overlying a substantial surface area portion of at least one surface of the barrier which faces one of the first and second regions, characterised in that said layer is a layer of conductive elastomeric material having a volume resistivity less than 0.01 Ω.cm and including a particulate electrically conductive filler consisting of a metal or metals in particulate form or particles of non-metal provided with a metallic coating.

2. A structure according to Claim 1 wherein the metal barrier (12) comprises sheet metal, overlapping metal strips or braided metal wire.

3. A structure according to Claim 1 or Claim 2 wherein the metal barrier (12) is formed from beryllium-copper, stainless steel, brass, aluminium or titanium.

4. A structure according to Claim 3 wherein the metal forming the metal barrier (12) is plated with a noble metal or silver.

5. A structure according to any of the preceding claims wherein the metal barrier (12) is discontinuous.

6. A structure according to any of the preceding claims wherein the conductive elastomeric material includes an elastomeric polymeric material.

7. A structure according to Claim 6 wherein the elastomeric polymer comprises a polychloroprene-, silicone- or fluorosilicone-based elastomer.

8. A structure according to any of the preceding claims wherein the electrically conductive particulate filler comprises particulate silver, silver plated copper, silver plated nickel, silver plated brass, silver plated aluminium or silver plated glass.

9. A structure according to any of the preceding claims wherein the electrically conductive particulate filler has a mean particle size less than 200 µm.

10. A structure according to any of the preceding claims including a layer (16) of non-conductive elastomeric material on the opposite side of the layer of conductive elastomeric material from the metal barrier.

11. An electromagnetic transmission line component comprising a structure as claimed in any of the preceding claims.

12. A method of reducing or substantially eliminating leakage of electromagnetic radiation between first and second regions lying on opposite sides of a conductive metal barrier (12), which comprises providing a layer (14) of material so as to overlie a substantial surface area portion of at least one surface of the barrier which faces one of the first and second regions, characterised in that said layer is a layer of conductive elastomeric material having a volume resistivity less than 0.01 Ω.cm and including a particulate electrically conductive filler consisting of a metal or metals in particulate form or particles of non-metal provided with a metallic coating.

13. A method according to Claim 12 wherein the metal barrier (12) comprises sheet metal, overlapping metal strips or braided metal wire.

14. A method according to Claim 12 or Claim 13 wherein the metal barrier (12) is formed from beryllium-copper, stainless steel, brass, aluminium or titanium.

15. A method according to Claim 14 wherein the metal forming the metal barrier (12) is plated with a noble metal or silver.

16. A method according to any of Claims 12 to 15 wherein the metal barrier (12) is discontinuous.

17. A method according to any of Claims 12 to 16 wherein the conductive elastomeric material includes an elastomeric polymeric material.

18. A method according to Claim 17 wherein the elastomeric polymer comprises a polychloroprene-, silicone- or fluorosilicone-based elastomer.

19. A method according to any of Claims 12 to 18 wherein the electrically conductive particulate filler comprises particulate silver, silver plated copper, silver plated nickel, silver plated brass, silver plated aluminium or silver plated glass.

20. A method according to any of Claims 12 to 19 wherein the electrically conductive particulate filler has a mean particle size less than 200 µm.

21. A method according to any of Claims 12 to 20 wherein a layer (16) of non-conductive elastomeric material is provided on the opposite side of the layer of conductive elastomeric material from the metal barrier.

22. A coaxial electromagnetic transmission line component having inner and outer electrically conductive elements electrically insulated from one another, characterised in that the outer electrically conductive element comprises a layer of electrically conductive elastomeric material having a volume resistivity of less than 0.01 Ω.cm and including a particulate electrically conductive filler consisting of a metal or metals in particulate form or particles of non-metal provided with a metallic coating.

23. A coaxial electromagnetic transmission line component according to Claim 22 wherein the conductive elastomeric material includes an elastomeric polymeric material.

24. A coaxial electromagnetic transmission line component according to Claim 23 wherein the elastomeric polymer comprises a polychloroprene-, silicone- or fluorosilicone-based elastomer.

25. A coaxial electromagnetic transmission line component according to Claim 22, 23 or 24 wherein the electrically conductive particulate filler comprises particulate silver, silver plated copper, silver plated nickel, silver plated brass, silver plated aluminium or silver plated glass.

26. A coaxial electromagnetic transmission line component according to any of Claims 22 to 25 wherein the electrically conductive particulate filler has a mean particle size less than 200 µm.

## Patentansprüche

1. Anordnung zur Benutzung beim Erschweren bzw. Behindern des Durchgangs von elektromagnetischer Strahlung, wobei die Struktur eine leitende Metallbarriere (12) umfaßt, um erste und zweite Bereiche, die sich auf entgegengesetzten Seiten der Barriere befinden, elektromagnetisch voneinander abzuschirmen, und eine Schicht (14) aus Material, die einen beträchtlichen Teil eines Oberflächeninhalts von mindestens einer Oberfläche der Barriere überlagert, die einem der ersten und zweiten Bereiche gegenüberliegt, dadurch gekennzeichnet, daß die Schicht eine Schicht aus leitendem, elastomerem Material ist, das einen spezifischen Volumenwiderstand von weniger als 0,01 Ω.cm. besitzt, und ein aus Partikeln bestehendes, elektrisch leitfähiges Füllmaterial enthält, das aus einem Metall oder Metallen in Partikelform oder nichtmetallischen Partikeln besteht, die mit einer metallischen Beschichtung versehen sind.

2. Anordnung nach Anspruch 1, bei der die Metallbarriere (12) Blech, überlappende Metallstreifen oder geflochtenen Metalldraht umfaßt.

3. Anordnung nach Anspruch 1 oder Anspruch 2, bei der die Metallbarriere (12) aus Beryllium-Kupfer, rostfreiem Stahl, Messing, Aluminium oder Titan gebildet ist.

4. Anordnung nach Anspruch 3, bei der das Metall, das die Metallbarriere (12) bildet, mit einem Edelmetall oder Silber plattiert ist.

5. Anordnung nach einem der vorhergehenden Ansprüche, bei der die Metallbarriere (12) diskontinuierlich ist.

6. Anordnung nach einem der vorhergehenden Ansprüche, bei der das leitfähige, elastomere Material ein elastomeres, polymeres Material enthält.

7. Anordnung nach Anspruch 6, bei der das elastomere Polymer ein Elastomer auf Basis von Polychloropren, Silicon oder Fluorosilicon umfaßt.

8. Anordnung nach einem der vorhergehenden Ansprüche, bei der das elektrisch leitfähige, aus Partikeln bestehende Füllmaterial aus Partikeln bestehendes Silber, silberplattiertes bzw. versilbertes Kupfer, silberplattiertes Nickel, silberplattiertes Messing, silberplattiertes Aluminium oder silberplattiertes Glas umfaßt.

9. Anordnung nach einem der vorhergehenden Ansprüche, bei der das elektrisch leitfähige, aus Partikeln bestehende Füllmaterial eine mittlere Partikelgröße von weniger als 200 µm besitzt.

10. Anordnung nach einem der vorhergehenden Ansprüche, die eine Schicht (16) aus nichtleitendem, elastomerem Material auf der gegenüberliegenden Seite der Schicht aus leitfähigem, elastomerem Material von der Metallbarriere einschließt.

11. Elektromagnetisches Übertragungsleitungsbauelement, das eine Anordnung nach einem der vorhergehenden Ansprüche umfaßt.

12. Verfahren des Reduzierens oder im wesentlichen Eliminierens von Streuung bzw. Ableitung bzw. Lecken von elektromagnetischer Strahlung zwischen ersten und zweiten Bereichen, die auf gegenüberliegenden Seiten einer leitfähigen Metallbarriere (12) liegen, welches das Bereitstellen einer Schicht (14) aus Material dergestalt umfaßt, daß ein beträchtlicher Teil eines Oberflächeninhalts von mindestens einer Oberfläche der Barriere überlagert ist, die einem der ersten und zweiten Bereiche gegenüberliegt, dadurch gekennzeichnet, daß die Schicht eine Schicht aus leitfähigem, elastomerem Material ist, das einen spezifischen Volumenwiderstand von weniger als 0,01 Ω.cm. aufweist, und ein aus Partikeln bestehendes, elektrisch leitfähiges Füllmaterial enthält, das aus einem Metall oder Metallen in Partikelform oder nichtmetallischen Partikeln besteht, die mit einer metallischen Beschichtung versehen sind.

13. Verfahren nach Anspruch 12, bei dem die Metallbarriere (12) Blech, überlappende Metallstreifen oder geflochtenen Metalldraht umfaßt.

14. Verfahren nach Anspruch 12 oder Anspruch 13, bei dem die Metallbarriere (12) aus Beryllium-Kupfer, rostfreiem Stahl, Messing, Aluminium oder Titan gebildet ist.

15. Verfahren nach Anspruch 14, bei dem das Metall, das die Metallbarriere (12) bildet, mit einem Edelmetall oder Silber plattiert bzw. überzogen ist.

16. Verfahren nach einem der Ansprüche 12 bis 15, bei dem die Metallbarriere (12) diskontinuierlich ist.

17. Verfahren nach einem der Ansprüche 12 bis 16, bei dem das leitfähige, elastomere Material ein elastomeres, polymeres Material enthält.

18. Verfahren nach Anspruch 17, bei dem das elastomere Polymer ein Elastomer auf Basis von Polychloropren, Silicon oder Fluorosilicon umfaßt.

19. Verfahren nach einem der Ansprüche 12 bis 18, bei dem das elektrisch leitfähige, aus Partikeln bestehende Füllmaterial aus Partikeln bestehendes Silber, silberplattiertes Kupfer, silberplattiertes Nickel, silberplattiertes Messing, silberplattiertes Aluminium oder silberplattiertes Glas umfaßt.

20. Verfahren nach einem der Ansprüche 12 bis 19, bei dem das elektrisch leitfähige, aus Partikeln bestehende Füllmaterial eine mittlere Partikelgröße von weniger als 200 µm besitzt.

21. Verfahren nach einem der Ansprüche 12 bis 20, bei dem eine Schicht (16) aus nichtleitendem, elastomerem Material auf der gegenüberliegenden Seite der Schicht aus leitfähigem, elastomerem Material von der Metallbarriere vorgesehen wird.

22. Koaxiales, elektromagnetisches Übertragungsleitungsbauelement, das innere und äußere elektrisch leitfähige Elemente aufweist, die voneinander elektrisch isoliert sind, dadurch gekennzeichnet, daß das äußere elektrisch leitfähige Element eine Schicht aus elektrisch leitfähigem, elastomerem Material umfaßt, das einen spezifischen Volumenwiderstand von weniger als 0,01 Ω.cm. besitzt, und ein aus Partikeln bestehendes, elektrisch leitfähiges Füllmaterial enthält, das aus einem Metall oder Metallen in Partikelform oder nichtmetallischen Partikeln besteht, die mit einer metallischen Beschichtung versehen sind.

23. Koaxiales, elektromagnetisches Übertragungsleitungsbauelement nach Anspruch 22, bei dem das leitfähige, elastomere Material ein elastomeres, polymeres Material enthält.

24. Koaxiales, elektromagnetisches Übertragungsleitungsbauelement nach Anspruch 23, bei dem das elastomere Polymer ein Elastomer auf Basis von Polychloropren, Silicon oder Fluorosilicon umfaßt.

25. Koaxiales, elektromagnetisches Übertragungsleitungsbauelement nach Anspruch 22, 23 oder 24, bei dem das elektrisch leitfähige, aus Partikeln bestehende Füllmaterial aus Partikeln bestehendes Silber, silberplattiertes Kupfer, silberplattiertes Nickel, silberplattiertes Messing, silberplattiertes Aluminium oder silberplattiertes Glas umfaßt.

26. Koaxiales, elektromagnetisches Übertragungsleitungsbauelement nach einem der Ansprüche 22 bis 25, bei dem das elektrisch leitfähige, aus Partikeln bestehende Füllmaterial eine mittlere Partikelgröße von weniger als 200 µm besitzt.

## Revendications

1. Structure pour l'utilisation en vue d'empêcher le passage de radiation électromagnétique, ladite structure comprenant une barrière de métal conducteur (12) pour le screening des première ou seconde régions situées l'une par rapport à l'autre, sur des faces opposées de la barrière électromagnétique, et une couche (14) de matériau recouvrant une substantielle portion de surface d'au moins une surface de la barrière faisant face à l'une des première et seconde régions, caractérisée en ce que ladite couche est une couche d'un matériau élastomère conducteur ayant une résistivité volumique inférieure à 0,01 Ω.cm, et comprenant une charge particulaire électro-conductrice consistant en un métal, ou en des métaux sous forme particulaire, ou en des particules non métalliques portant un revêtement métallique.

2. Structure selon la revendication 1, dans laquelle la barrière métallique (12) comprend une feuille de métal, des bandes de métal se recouvrant, ou des fils métalliques entrelacés.

3. Structure selon la revendication 1, ou la revendication 2, dans laquelle la barrière métallique (12) est formée de béryllium-cuivre, d'acier inoxydable, de bronze, d'aluminium, ou de titane.

4. Structure selon la revendication 3, dans laquelle le métal formant la barrière métallique (12), est plaqué avec un métal précieux, ou avec de l'argent.

5. Structure selon l'une quelconque des revendications précédentes, dans laquelle la barrière métallique (12) est discontinue.

6. Structure selon l'une quelconque des revendications précédentes, dans laquelle le matériau élastomère conducteur comprend un matériau polymère élastomère.

7. Structure selon la revendication 6, dans laquelle le polymère élastomère comprend un élastomère à base de polychloroprène, de silicones, ou de fluorosilicones.

8. Structure selon l'une quelconque des revendications précédentes, dans laquelle la charge particulaire électro-conductrice comprend de l'argent particulaire, du cuivre plaqué avec de l'argent, du nickel plaqué avec de l'argent, du bronze plaqué avec de l'argent, de l'aluminium plaqué avec de l'argent, ou du verre plaqué avec de l'argent.

9. Structure selon l'une quelconque des revendications précédentes, dans laquelle la charge particulaire électro-conductrice a une taille moyenne de particules inférieure à 200 µm.

10. Structure selon l'une quelconque des revendications précédentes, comprenant une couche (16) d'un matériau élastomère non conducteur, sur la face opposée de la couche de matériau élastomère conducteur par rapport à la barrière métallique.

11. Composant de ligne de transmission électromagnétique comprenant une structure selon l'une quelconque des revendications précédentes.

12. Méthode de réduction, ou d'élimination substantielle des fuites de radiation électromagnétique entre les première et seconde régions s'étendant sur des faces opposées d'une barrière métallique conductrice (12), qui comprend la mise en place d'une couche (14) de matériau, de façon à recouvrir une substantielle portion de surface d'au moins une surface de la barrière, faisant face à l'une des première ou seconde régions, caractérisée en ce que ladite couche est une couche d'un matériau élastomère conducteur ayant une résistivité volumique inférieure à 0,01 Ω.cm, et comprenant une charge particulaire électro-conductrice consistant en un métal, ou en des métaux sous forme particulaire, ou en des particules non métalliques portant un revêtement métallique.

13. Méthode selon la revendication 12, dans laquelle la barrière métallique (12) comprend une feuille de métal, des bandes de métal se recouvrant, ou des fils métalliques entrelacés.

14. Méthode selon la revendication 12, ou la revendication 13, dans laquelle la barrière métallique (12) est formée de béryllium-cuivre, d'acier inoxydable, de bronze, d'aluminium, ou de titane.

15. Méthode selon la revendication 14, dans laquelle le métal formant la barrière métallique (12), est plaqué avec un métal précieux, ou avec de l'argent.

16. Structure selon l'une quelconque des revendications 12 à 15, dans laquelle la barrière métallique (12) est discontinue.

17. Méthode selon l'une quelconque des revendications 12 à 16, dans laquelle le matériau élastomère conducteur comprend un matériau polymère élastomère.

18. Méthode selon la revendication 17, dans laquelle le polymère élastomère comprend un élastomère à base de polychloroprène, de silicones, ou de fluorosilicones.

19. Méthode selon l'une quelconque des revendications 12 à 18, dans laquelle la charge particulaire électro-conductrice comprend de l'argent particulaire, du cuivre plaqué avec de l'argent, du nickel plaqué avec de l'argent, du bronze plaqué avec de l'argent, de l'aluminium plaqué avec de l'argent, ou du verre plaqué avec de l'argent.

20. Méthode selon l'une quelconque des revendications 12 à 19, dans laquelle la charge particulaire électro-conductrice a une taille moyenne de particules inférieure à 200 µm.

21. Méthode selon l'une quelconque des revendications 12 à 20, comprenant une couche (16) d'un matériau élastomère non conducteur, sur la face opposée de la couche de matériau élastomère conducteur par rapport à la barrière métallique.

22. Composant de ligne co-axiale de transmission de radiation électromagnétique ayant des éléments électro-conducteurs intérieur et extérieur, électriquement isolés l'un de l'autre, caractérisé en ce que l'élément électro-conducteur externe comprend une couche de matériau élastomère électro-conducteur ayant une résistivité volumique inférieure à 0,01 Ω.cm, et comprenant une charge particulaire électro-conductrice consistant en un métal, ou en des métaux sous forme particulaire, ou en des particules non métalliques portant un revêtement métallique.

23. Composant de ligne co-axiale de transmission de radiation électromagnétique selon la revendication 22, dans lequel le matériau élastomère conducteur comprend un matériau polymère élastomère.

24. Composant de ligne co-axiale de transmission de radiation électromagnétique selon la revendication 23, dans lequel le polymère élastomère comprend un élastomère à base de polychloroprène, de silicones, ou de fluorosilicones.

25. Composant de ligne co-axiale de transmission de radiation électromagnétique selon la revendication 22, 23, ou 24, dans lequel la charge particulaire électro-conductrice comprend de l'argent particulaire, du cuivre plaqué avec de l'argent, du nickel plaqué avec de l'argent, du bronze plaqué avec de l'argent, de l'aluminium plaqué avec de l'argent, ou du verre plaqué avec de l'argent.

26. Composant de ligne co-axiale de transmission de radiation électromagnétique selon l'une quelconque des revendications 22 à 25, dans lequel la charge particulaire électro-conductrice a une taille moyenne de particules inférieure à 200 µm.
